# EUROPÄISCHE PATENTSCHRIFT

(11) **EP 0 705 439 B1**
(45) Veröffentlichungstag und Bekanntmachung des Hinweises auf die Patenterteilung: **03.09.1997**
(21) Anmeldenummer: 94919624.0
(22) Anmeldetag: 11.06.1994
(51) Int. Cl.: G01R 31/04

(54) **TESTVORRICHTUNG SOWIE -VERFAHREN FÜR EINEN AUF EINER PLATINE EINGELÖTETEN IC**
PROCESS AND DEVICE FOR TESTING AN INTEGRATED CIRCUIT SOLDERED ON A BOARD
PROCEDE ET DISPOSITIF PERMETTANT DE TESTER UN CIRCUIT INTEGRE BRASE SUR UNE PLATINE

(30) Priorität: 15.06.1993 DE 4319710
(43) Veröffentlichungstag der Anmeldung: 10.04.1996
(73) Patentinhaber: ITA INGENIEURBÜRO FÜR TESTAUFGABEN GmbH, D-22769 Hamburg (DE)
(72) Erfinder: BUKS, Manfred, D-24558 Henstedt-Ulzburg (DE); HOSSEINI, Karim, D-22763 Hamburg (DE)
(74) Vertreter: Schaefer, Konrad, Dipl.-Phys.
(86) Internationale Anmeldenummer: EP9401902
(87) Internationale Veröffentlichungsnummer: WO9429738

(56) Entgegenhaltungen:
- EP-A- 0 305 148
- DE-C- 4 110 551
- ELECTRONIQUE, Nr.27, April 1993, PARIS FR Seiten 42 - 45 SCHWARTZ 'LE TEST STRUCTUREL SE FIABILISE'

## Beschreibung

Die Erfindung betrifft eine Testvorrichtung der in den Oberbegriffen der Ansprüche 1 bis 3 genannten Art sowie ein Testverfahren der in den Oberbegriffen der Ansprüche 8 bis 10 genannten Art.

Eine solche Testvorrichtung mit entsprechendem Verfahren ist aus der
DE-C-41 10 551
bekannt. Es werden damit in einem IC vorhandene, von außen über Pins des ICs abgreifbare parasitäre Transistoren bestimmt, die sich aus im Substrat des ICs gegen Masse gebildeten Dioden des ICs zusammensetzen. Bei diesen Dioden handelt es sich um parasitäre Dioden. Die daraus gebildeten Transistoren werden daher als parasitäre Transistoren oder laterale Transistoren bezeichnet.

Die Transistormessung erfolgt in der sogenannten Emitterschaltung, bei der der Emitter des Transistors an der Masse des Testers liegt.

Dabei ist die Basis des Transistors, die dem GND-Pin (Groundpin) des ICs entspricht, nicht, wie bei ICs üblich, an Masse gelegt, sondern an eine zur Aufsteuerung des Transistors geeignete Basisspannung. Zwei Signalpins des ICs werden als Kollektor bzw. Emitter angeschlossen. Die jeweils zwischen GND und den Signalpins liegenden Dioden bilden die Emitter- und Kollektordiode des Transistors. Der Kollektorstrom wird gemessen. Dieser zu bestimmende Transistor wird im folgenden als "Testtransistor" bezeichnet.

Vorteilhaft dabei ist die gegenüber älteren Testverfahren, beispielsweise der Knotenimpedanzmessung verbesserte Möglichkeit, auf komplexen Platinen mit vielen ICs, von denen viele Pins parallel verbunden sind, also insbesondere bei Busschaltungen, Aussagen über die korrekte Verlötung der Pins zu machen.

Bei in bipolarer Technik (TTL-Logik) ausgeführten ICs lassen sich auf diese Weise sehr gut die vorhandenen Testtransistoren bestimmen. Es haben sich aber Schwierigkeiten beim Testen von in CMOS-Technik gefertigten ICs herausgestellt, die sich zunehmend durchsetzen. Heutige höher integrierte ICs werden nahezu ausschließlich in CMOS-Technik gefertigt.

Es hat sich herausgestellt, daß bei CMOS-ICs sogar bei Messung isolierter ICs mit offenen Pins (also im nicht eingelöteten Zustand) ungeklärte Probleme ergeben, die in der Fachwelt in jüngster Zeit unter dem Stichwort "Hintergrundstrom" bekannt wurden. Wenn bei einem CMOS-IC ein Testtransistor gemessen wird, so ergeben sich Ströme, die wesentlich höher sind als die von dem Testtransistor erwarteten Ströme. Es fließt also offenbar zu dem durch den Testtransistor fließenden Strom ein im folgenden als Zusatzstrom bezeichneter Strom, der in der Fachwelt auch als "Hintergrundstrom" bezeichnet wird. Dieser Zusatzstrom hängt sehr stark von Fertigungsparametern des ICs ab, wie z.B. unterschiedliche Hersteller oder unterschiedliche Fertigungschargen.

Es ist dabei schwierig oder unmöglich, den Strom des Testtransistors vom Zusatzstrom zu trennen. Da der Zusatzstrom in den meisten Fällen wesentlich höher ist als der Strom des Testtransistors, lassen sich keine Aussagen über die Eigenschaften des Testtransistors machen.

Liegen aufgrund paralleler Verbindungen zwischen Pins des ICs mehrere Testtransistoren parallel, so könnte man, wenn man den Strom eines Testtransistors kennt, aus dem gemessenen Strom der Parallelschaltung auf die Anzahl der Testtransistoren schließen, da die Testtransistoren eines ICs zumeist sehr ähnliche Eigenschaften haben. Fließt aber der zusätzliche sehr hohe Zusatzstrom, so lassen sich solche Aussagen über die Anzahl parallel liegender Testtransistoren nicht mehr treffen.

Die Aufgabe der vorliegenden Erfindung besteht daher darin, Testvorrichtungen und Verfahren der eingangs genannten Art zu schaffen, die auch bei CMOS-ICs die Bestimmung von Testtransistoren mit hoher Genauigkeit und insbesondere in hoher Auflösung gegenüber dem Zusatzstrom ermöglichen.

Diese Aufgabe wird erfindungsgemäß mit den Merkmalen der Vorrichtungsansprüche 1 bis 3 sowie der Verfahrensansprüche 6 bis 8 gelöst.

Die Erfindung geht von der Erkenntnis aus, daß bei CMOS-ICs bei Öffnen eines Testtransistors, also eines Transistors mit Masse an einem Signalpin, Basis an GND und Kollektor an einem anderen Signalpin, stets auch ein im folgenden als Zusatztransistor bezeichneter Transistor geöffnet wird, und zwar ohne daß andere Pins des ICs mit der Testvorrichtung kontaktiert sind. Bei dem Zusatztransistor handelt es sich um einen Transistor mit Kollektor an dem Versorgungsspannungspin V_{cc}. Dieser Zusatztransistor ist bei allen ICs, also bei CMOS-ICs und auch bei bipolaren ICs vorhanden. Er ist gebildet aus einer zwischen GND und V_{cc} liegenden parasitären Diode, die in allen ICs vorhanden ist und die als Kollektordiode arbeitet, sowie einer beliebigen zwischen GND und dem als Emitter an Masse angeschlossenen Signalpin liegenden Diode als Emitterdiode. Bei Beaufschlagung eines Testtransistors mit Kollektor, Basis und Emitter hat der Zusatztransistor also denselben Emitter, dieselbe Basis, jedoch den V_{cc}-Pin als Kollektor.

Wird der Versorgungsspannungspin V_{cc} nicht von außen kontaktiert und mit einer Kollektorspannung beaufschlagt, so ist bei einem bipolaren IC der Zusatztransistor ohne Kollektorspannung. Bei CMOS-ICs sind die Verhältnisse aber anders.

Bei CMOS-ICs liegt zwischen jedem Signalpin und dem Versorgungsspannungspin V_{cc} eine parasitäre Diode mit Durchlaßrichtung vom Signalpin zum Versorgungsspannungspin. Wird also bei einem CMOS-IC an einen Signalpin eine Kollektorspannung angelegt, so fließt Strom zum Versorgungsspannungspin V_{cc} und legt dort eine, durch die dazwischenliegende Diode bedingt etwas niedrigere, aber ausreichende Spannung an, die im folgenden als Zusatzspannung bezeichnet wird. Der an dem als Kollektor beschalteten Signalpin gemessene Kollektorstrom setzt sich daher zusammen aus dem Strom, der durch den Testtransistor fließt, und dem Strom, der über die besagte Diode durch den Zusatztransistor fließt.

Leider hat die zwischen GND und V_{cc} liegende Diode regelmäßig die unangenehme Eigenschaft, daß sie wesentlich höhere Durchlaßwerte aufweist als die zwischen GND und Signalpins liegenden, als Kollektordioden arbeitenden Dioden. Der Zusatztransistor weist also zumeist wesentlich höhere Stromverstärkungswerte auf als alle Testtransistoren. Wird bei Messung des Kollektorstromes eines Testtransistors die Summe des Stromes des Testtransistors und des Stromes des Zusatztransistors gemessen, so ist der interessierende, von dem Testtransistor erzeugte Anteil gegenüber dem Gesamtstrom sehr klein, und es lassen sich somit keine genauen Aussagen über den Strom und über die Eigenschaften des Testtransistors machen. Der durch den Zusatztransistor fließende Zusatzstrom ist der Strom, der in der jüngeren Literatur auch als "Hintergrundstrom" bezeichnet wird.

Besonders unangenehm ist die Tatsache, daß auf einer mit ICs bestückten Platine regelmäßig die Massepins GND und die Versorgungsspannungspins V_{cc} aller ICs parallel geschaltet sind. Ferner sind zumeist auch, insbesondere bei Busstrukturen, Signalpins mehrerer ICs parallel geschaltet. Werden parallel geschaltete Signalpins als Emitter von zu messenden Testtransistoren verwendet, so liegen Zusatztransistoren in mehreren ICs parallel und werden bei Messung eines Testtransistors geöffnet. Es ergeben sich dann derart hohe Zusatzströme, daß auch mit Testvorrichtungen höchster Genauigkeit der Kollektorstrom des zu bestimmenden Testtransistors nicht mehr festgestellt werden kann.

Der Erfindung gelingt es, die Kollektorströme von Testtransistoren und die Zusatzströme zu trennen, so daß Testtransistoren mit hoher Genauigkeit gemessen werden können.

Mit einer Testvorrichtung nach Anspruch 1 bzw. dem Verfahren nach Anspruch 8 geschieht dies dadurch, daß zunächst in herkömmlicher Weise der Kollektorstrom des Testtransistors bestimmt wird, der sich als Summe des Stromes durch den eigentlichen Testtransistor und des Stromes des Zusatztransistors ergibt. Die dabei über die den als Kollektor verwendeten Signalpin und den Versorgungsspannungsanschluß V_{cc} verbindende Diode am Versorgungsspannungspin auftretende Zusatzspannung wird gemessen, und es wird in einem zweiten Schritt der Kollektor des Testtransistors abgeschaltet und nur der Zusatztransistor allein betrieben unter Anlegung der zuvor gemessenen Zusatzspannung und der vorher verwendeten Basisspannung. Der Zusatztransistor wird also mit denselben Parametern betrieben, mit denen er vorher zusammen mit dem Testtransistor betrieben wurde. Es wird der Zusatzstrom gemessen und kann nun von dem zuvor gemessenen Kollektorstrom abgezogen werden, woraus sich der korrigierte Kollektorstrom ergibt, der nur dem Strom entspricht, der allein durch den Testtransistor fließt. Nach Anspruch 4 kann vorteilhaft diese Differenzbildung automatisch von der Testvorrichtung vorgenommen werden.

Alternativ kann mit einer Testvorrichtung nach Anspruch 2 bzw. dem Verfahren nach Anspruch 9 der Zusatzstrom dadurch bestimmt werden, daß wiederum zunächst in herkömmlicher Weise der Testtransistor gemessen wird (einschließlich Zusatzstrom), die Zusatzspannung an V_{cc} bestimmt wird und sodann unter Abschaltung von Basis und Emitter lediglich an dem zuvor als Kollektor verwendeten Signalpin die zuvor verwendete Kollektorspannung und an dem Versorgungsspannungspin V_{cc} die zuvor gemessene Zusatzspannung angelegt werden. Es fließt dann über die zwischen diesen Pins bestehende Diode der Zusatzstrom und kann gemessen und anschließend von dem zuvor ermittelten Kollektorstrom abgezogen werden, vorteilhaft automatisch gemäß Anspruch 5.

Schließlich kann mit einer weiteren alternativen Testvorrichtung gemäß Anspruch 3 bzw. dem entsprechenden Verfahren gemäß Anspruch 10 gleichzeitig mit der herkömmlichen Messung des Testtransistors eine der an diesen angelegten Kollektorspannung entsprechende Zusatzspannung gleicher Höhe an den Versorgungsspannungspin V_{cc} angelegt werden, jedoch aus einer getrennten Spannungsquelle. Die zwischen dem als Kollektor angeschlossenen Signalpin und dem Versorgungsspannungspin liegende Diode ist nun geguarded. An ihren beiden Enden herrscht dieselbe Spannung. Es fließt also durch die Diode kein Strom. Der Kollektorstrom des Testtransistors und der Zusatzstrom durch den Zusatztransistor kommen aus unterschiedlichen, getrennten Spannungsquellen, so daß am Kollektor des Testtransistors direkt der diesem zugehörige Strom unabhängig vom Zusatzstrom, also der korrigierte Kollektorstrom bestimmt werden kann.

Wenn das Meßergebnis um den Zusatzstrom korrigiert wird, der den Strom des Testtransistors um mehrere Größenordnungen übersteigen kann, so ergibt sich eine hochgenaue Messung des Testtransistors. Es können also Aussagen über individuelle Unterschiede unterschiedlicher in einem IC vorliegender Testtransistoren gemacht werden, und es ist auch möglich, bei mehreren parallel liegenden Testtransistoren anzugeben, wie viele dies sind, also ob z.B. einer von drei parallelliegenden Testtransistoren fehlt.

Von großem Vorteil ist auch, daß die starken, bei gleichen IC-Typen unterschiedlicher Hersteller oder bei Fertigungsschwankungen auftretenden Schwankungen des Hintergrundstromes nicht mehr stören. Es können also Platinen getestet werden, die wahllos mit ICs desselben Typs bestückt sind, die von unterschiedlichen Herstellern oder aus unterschiedlichen Chargen stammen.

Bei jeweiliger Kontaktierung eines Testtransistors mit dem Tester zur Überprüfung der korrekten Kontaktierung der jeweiligen als Kollektor oder Emitter angeschlossenen Pins mit ihren Leiterbahnen kann mit dem Tester untersucht werden, ob der kontaktierte Testtransistor sich wie ein Transistor verhält. Es kann also beispielsweise die Stromverstärkung gemessen werden, eine Transistorkennlinie mit mehreren Messungen durchgefahren werden oder eine sonstige typische Transistoreigenschaft bestimmt werden. Wenn nach Überprüfung feststeht, daß sich der kontaktierte Testtransistor wie ein Transistor verhält, dann steht fest, daß die kontaktierten Pins korrekt verlötet sind und daß die inneren Anschlüsse des Pins im IC in Ordnung sind, also nicht beispielsweise durch zu hohe Löttemperaturen zerstört wurden.

Man kann aber auch einfach nur mit einer Messung bei einem mit dem Tester kontaktierten Testtransistor den Kollektorstrom messen und entscheiden, ob dieser Kollektorstrom bei den vorgegebenen Basis- und Kollektorspannungen dem von dem jeweiligen Testtransistor erwarteten Strom entspricht.

Man käme dann für jeden Testtransistor mit nur einer Strommessung aus, ohne weitere Messungen und ohne zusätzliche Rechenschritte, beispielsweise zur Ermittlung der Stromverstärkung oder zur Auswertung einer Meßkurve. Nachteilig bei dieser einfachen Methode ist aber, daß der Kollektorstrom eines bestimmten, an einem IC zu messenden Testtransistors eines IC-Typs sehr stark zwischen ICs desselben Typs schwankt, die von unterschiedlichen Herstellern oder aus unterschiedlichen Herstellungschargen stammen. Die Ströme können sich bis weit über den Faktor 10 unterscheiden. Wenn zu prüfende Platinen also gemischt mit ICs unterschiedlicher Hersteller oder unterschiedlicher Chargen versehen sind, führt diese Methode zu Problemen.

Diese können mit einer Testvorrichtung nach Anspruch 6 bzw. dem Testverfahren nach Anspruch 11 gelöst werden. Die auf die angegebene Weise bestimmten normierten Kollektorströme, die also beispielsweise angeben, daß für einen Testtransistor der Strom das 1,2fache des Mittelwertes beträgt, sind unabhängig von Hersteller- oder Chargenschwankungen, da die Stromwerte der einzelnen Testtransistoren sich genauso verändern wie die Mittelwerte. Wenn also bei einem gemessenen Testtransistor der normierte Kollektorstrom das 1,2fache des Mittelwertes beträgt, so ist dies der Fall, unabhängig davon, ob der Kollektorstrom bei einem IC eines Herstellers 50 µA beträgt, oder bei dem IC eines anderen Herstellers 2 mA.

Vorteilhaft werden dabei aber gemäß Anspruch 7 bzw. Anspruch 12 zur Normierung nur die Mittelwerte von Gruppen solcher Testtransistoren verwendet, die jeweils dieselbe Pinart bei den Kollektoren und Emittern haben. Ein Testtransistor mit einem Eingangspin I als Kollektor und einem Ausgangspin O als Emitter gehört also zu einer Gruppe I - O, während ein Testtransistor mit einem Ausgangspin O als Kollektor und einem Eingangspin I als Emitter zu einer Gruppe O - I gehört. Weitere Gruppen sind z.B. I - I, O - O oder Gruppen, die mit anderen Pinarten gebildet werden, wie z.B. Enable-Pins oder Chipselect-Pins. Wenn auf diese Weise die Mittelwerte nur aus solchen Gruppen untereinander sehr ähnlicher Testtransistoren gebildet werden, so ist sichergestellt, daß sich bei ICs von unterschiedlichen Herstellern oder aus unterschiedlichen Chargen die Mittelwerte mit großer Genauigkeit wie die Kollektorströme einzelner Testtransistoren ändern. Es ist dabei auch berücksichtigt, daß zwischen unterschiedlichen Herstellern oder Chargen sich die Mittelwerte von Gruppen unterschiedlich ändern können.

Nach Anspruch 13 ist ein Verfahren vorteilhaft, bei dem zunächst mit einer als einwandfrei bekannten Platine die normierten Ströme aller Testtransistoren bestimmt werden und sodann diese Tabelle von normierten Strömen mit den an den entsprechenden Testtransistoren bestimmten normierten Strömen einer zu testenden Platine verglichen werden. Durch einfachen Tabellenvergleich kann über "gut" oder "Fehler" entschieden werden.

In den Zeichnungen ist die Erfindung beispielsweise und schematisch dargestellt. Es zeigen:
- Fig. 1: das Diodenersatzschaltbild eines CMOS-IC,
- Fig. 2: das Ersatzschaltbild der Fig. 1 in Transistordarstellung mit angeschlossenem Tester,
- Fig. 3: ein Ersatzschaltbild gemäß Fig. 1 eines ICs mit der doppelten Anzahl von Signalpins,
- Fig. 4: das Ersatzschaltbild der Fig. 3 in Transistordarstellung und
- Fig. 5: zwei ICs in Darstellung entsprechend Fig. 4 in parallel vernetzter Verschaltung auf einer Platine.

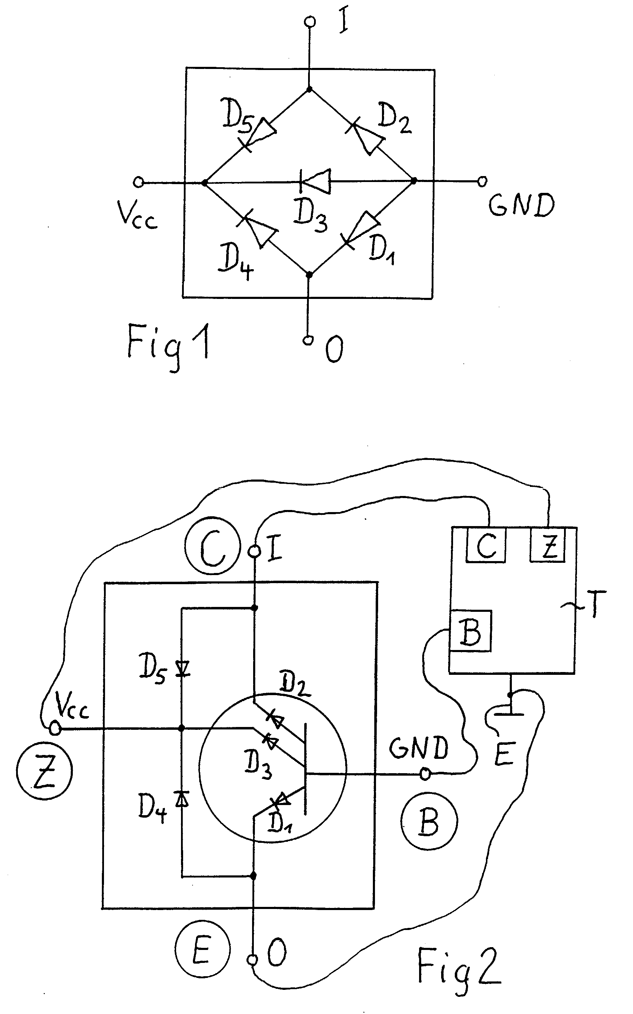

Fig. 1 zeigt das Diodenersatzschaltbild eines CMOS-ICs. Zur Vereinfachung der Darstellung handelt es sich um einen IC mit nur zwei Signalpins I und O (Input, Output). Der Versorgungsspannungspin ist mit V_{cc} bezeichnet. Der Massepin des ICs ist mit GND bezeichnet. Es sind die von außen bei Messungen zwischen den Pins feststellbaren Dioden D₁ bis D₅ eingezeichnet. Dabei handelt es sich um bipolare Dioden auf dem Substrat des ICs, die zumeist parasitäre Dioden sind, also nicht solche Dioden, die vom IC-Hersteller absichtlich angeordnet wurden, sondern um Dioden, die sich aus Strukturen des ICs im Substrat gegenüber Masse von selbst ergeben.

Es liegen also stets die Dioden D₁ und D₂ in der dargestellten Polung zwischen Signalpins und GND, die Dioden D₄ und D₅ zwischen den Signalpins und V_{cc}, und es existiert die Diode D₃ zwischen V_{cc} und GND.

Bei diesen Dioden handelt es sich um bipolare Dioden mit niedrigem Innenwiderstand, durch die bei niedrigen Spannungen hohe Ströme fließen, verglichen mit den Strömen, die in den nicht dargestellten hochkomplexen MOSFET-Schaltkreiseu des CMOS-ICs fließen. Die gesamte, nicht dargestellte CMOS-Logik des ICs kann daher bei der Betrachtung von Strömen, die durch die dargestellten Dioden D₁ bis D₅ fließen, unberücksichtigt bleiben. Ebenso sind vernachlässigbar alle im IC vorhandenen Ohm'schen Widerstände oder Kapazitäten, die dem niedrigen Stromniveau der MOSFET-Schaltungen angepaßt sind und bei Betrachtung von Strömen durch die Dioden D₁ bis D₅ folglich vernachlässigbar sind. Auch zu Schutzzwecken an den Signalpins vorgesehene sogenannte Clamping-Dioden stören nicht, da sie zumeist mit Vorwiderständen versehen sind und somit nur vergleichsweise niedrige, also unbeachtliche Ströme fließen lassen. Stören können allenfalls dann die MOSFET-Schaltkreise, wenn die Versorgungsspannung an V_{cc} so hoch liegt, daß die MOSFETs aufsteuern. Auf der Eingangsseite sind sie zwar sehr hochohmig, sie weisen aber sehr niedrige Ausgangswiderstände auf, die die Messungen stören können. Das reine Diodenersatzschaltbild der Fig. 1 gilt daher nur dann, wenn die Versorgungsspannung an V_{cc} unter der Spannung liegt, bei der die Feldeffekttransistoren der CMOS-Logik öffnen. Diese Spannung liegt bei konventionellen CMOS-ICs im Bereich 2 Volt, kann bei modernen ICs für batteriegetriebene Geräte aber niedriger liegen bis etwas unter 1 Volt. Dies kann bei Anlegung der Meßspannungen berücksichtigt werden.

Da die Dioden D₁ und D₂ auf demselben Substrat angeordnet sind, können sie einen Testtransistor mit Basis an GND bilden, wobei I den Kollektor und O den Emitter oder umgekehrt bilden können. Fig. 2 zeigt dies in der üblichen Transistordarstellung (Kreis). Die Basis des Testtransistors liegt an GND. D₂ bildet die Kollektordiode, D₁ bildet die Emitterdiode.

Es ist gemäß Fig. 2 ein Tester T vorgesehen, der mit einem Kollektorausgang C an den Signalpin I angeschlossen ist, mit einem Basisanschluß B an den Massepin GND und mit einem Masseanschluß E, der als Emitter dient, an den Signalpin O. Zur Verdeutlichung ist neben den Pins I, GND und O angegeben, daß diese an Kollektor C, Basis B und Emitter E geschaltet sind. Es liegt die Emitterschaltung eines Transistors mit Emitter an Masse vor.

Bei der bis jetzt beschriebenen Beschaltung eines Testtransistors, der aus den Dioden D₂ und D₁ gebildet ist, läßt sich bei bipolaren ICs, bei denen die Diode D₅ fehlt, der aus D₂ und D₁ gebildete Testtransistor exakt ausmessen, wenn V_{cc} unbeschaltet ist. Bei CMOS-ICs ist dies aber nicht möglich, weil dort die Diode D₅ vorhanden ist.

Aufgrund der Polarität der Dioden ist der aus den Dioden D₁ und D₂ gebildete Testtransistor ein pnp-Transistor. Die Kollektorspannung ist also positiv gegenüber dem Emitter. Die bei CMOS-ICs vorhandene Diode D₅ liegt folglich in Durchlaßrichtung, so daß an V_{cc} eine Spannung anliegt, die der Kollektorspannung an I entspricht, verringert um die Durchlaßspannung der Diode D₅. Wenn aber an V_{cc} eine als Kollektorspannung geeignete Spannung liegt, so bildet sich ein Zusatztransistor, bestehend aus den Dioden D₃ und D₁, mit Kollektor an V_{cc}, Emitter an O und Basis an GND.

Diese Verhältnisse sind in Fig. 2 dargestellt, die die Schaltung der Fig. 1 in anderer Darstellungsweise zeigt. Der Transistor (Kreis) weist eine gemeinsame Emitterdiode D₁ auf und zwei Kollektordioden D₂ und D₃. Der Kollektor des Testtransistors liegt an I. Der Kollektor des Zusatztransistors liegt an V_{cc}.

Die bisher noch nicht erwähnte Diode D₄ kann bei diesen Betrachtungen unberücksichtigt bleiben, da sie in jedem Fall in Sperrichtung liegt.

Die Diode D₃, die als Kollektordiode des Zusatztransistors D₃, D1 dient, hat leider die unangenehme Eigenschaft, daß ein mit ihr gebildeter Transistor eine erheblich höhere Stromverstärkung hat als alle Testtransistoren, die als Kollektor einen Signalpin aufweisen. Trotz der etwas geringeren Kollektorspannung des Zusatztransistors zieht dieser einen wesentlich größeren Strom. Die Stromverstärkung β ist wesentlich höher, und zwar bis zu mehreren Größenordnungen höher. Aussagen über die Eigenschaften des Testtransistors D₂, D₁, also z.B. über seine Stromverstärkung, lassen sich daher nicht treffen, weil die Stromverstärkung und somit die Ströme des Zusatztransistors D₃, D₁ bei ICs desselben Typs sehr stark schwanken können, beispielsweise zwischen ICs unterschiedlicher Hersteller oder unterschiedlicher Herstellungschargen.

Will man den Testtransistor D₂, D₁ messen, ergibt sich also durch den Zusatztransistor D₃, D₁ ein sehr viel höherer Hintergrundstrom, der die Messung stört. Um diesen zu korrigieren, weist der Tester T einen Zusatzanschluß Z an, der an V_{cc} angeschlossen ist.

Der Tester T ist dabei derart ausgebildet, daß er in zwei Betriebsarten umschaltbar ist wie folgt:

In einer ersten Betriebsart wird, wie bereits besprochen, mit dem Kollektoranschluß C des Testers T an I eine Kollektorspannung angelegt. Mit dem Basisausgang B des Testers wird an GND eine Basisspannung angelegt. O des ICs ist mit dem Masseanschluß E (Emitter) des Testers verbunden. Es wird nun der durch C fließende Kollektorstrom bestimmt. Dieser entspricht, wie bereits erwähnt, der Summe der Ströme durch den Testtransistor D₂, D₁ und durch den Zusatztransistor D₃, D₁. Außerdem wird bei dieser Messung in der ersten Betriebsart die Spannung an V_{cc} über den Zusatzanschluß Z des Testers T gemessen.

Anschließend schaltet der Tester T in die zweite Betriebsart um. Bei dieser wird der Kollektoranschluß C gesperrt. An V_{cc} wird über den Zusatzanschluß Z des Testers T die zuvor in der ersten Betriebsart an V_{cc} gemessene Spannung angelegt. Die Basisspannung an GND wird in derselben Höhe gewählt wie bei der ersten Betriebsart.

Damit ist sichergestellt, daß in der zweiten Betriebsart der Kollektor C stromlos ist und an Kollektor Z, Basis B und Emitter E des Zusatztransistors D₃, D₁ genau dieselben Verhältnisse vorliegen wie bei der ersten Betriebsart. Am Zusatzanschluß Z des Testers T wird nun der Kollektorstrom des Zusatztransistors, also der Zusatzstrom bestimmt.

Anschließend werden die an C und Z in den beiden Betriebsarten bestimmten Ströme voneinander dividiert. Es wird also von dem Gesamtkollektorstrom, der sich aus der Parallelschaltung der Testtransistoren D₂, D₁ mit dem Zusatztransistor D₃, D₁ ergibt, der Zusatzstrom des Zusatztransistors D₃, D₁ abgezogen. Als Resultatergibt sich der korrigierte Kollektorstrom des Testtransistors D₂, D₁.

Da der Gesamtkollektorstrom beider Transistoren und der Zusatzstrom bei identischen Parametern bestimmt werden, läßt sich mit dieser Korrektur der isolierte Kollektorstrom des Testtransistors D₂, D₁ mit sehr hoher Genauigkeit bestimmen. Es lassen sich also mit geeigneten Meßverfahren z.B. ein Vergleich von Basisstrom und Kollektorstrom zur Bestimmung der Stromverstärkung β oder durch Bestimmung von Transistorkennlinien bei Messung mehrerer Betriebspunkte, jeweils mit entsprechender Korrektur des Zusatzstromes, also jeweils Messung in beiden Betriebsarten, die individuellen Eigenschaften des Testtransistors D₂, D₁ hochgenau bestimmen.

In Fig. 2 wurde erläutert, daß der Pin I als Kollektor und der Pin O als Emitter für den Transistortest beschaltet werden. Da, wie Fig. 1 zeigt, die Diodenanordnung hinsichtlich der Signalpins I und O vollkommen symmetrisch ist, kann auch O als Kollektor und I als Emitter verwendet werden. Wenn O der Kollektor des Testransistors ist, so sorgt die nun durchlassende Diode D₄ für die Verbindung zu V_{cc}. D₅ ist in diesem Fall gesperrt. Die in Fig. 2 dargestellte Transistordarstellung (mit einem Kreis), die einen Transistor mit Emitterdiode D₁ und zwei parallelen Kollektordioden D₂ und D₃ zeigt, wäre für den soeben beschriebenen Fall anders darzustellen. Es wären dann nur D₂ die Emitterdiode, während D₃ und D₁ die parallelen Kollektordioden bilden.

Wie bereits zu Fig. 1 erwähnt, sollte dafür Sorge getragen werden, daß die an V_{cc} auftretenden Spannungen, die den Zusatztransistor D₃, D₁ öffnen, nicht zu hoch sind, damit die interne CMOS-Logik nicht öffnet, also an ihren Ausgängen niederohmig wird. Je nach Art der CMOS-ICs ist also dafür Sorge zu tragen, daß die an V_{cc} auftretende Zusatzspannung nicht über etwa 1 Volt oder etwa 2 Volt kommt. Auch darf die Basisspannung an GND nicht zu hoch sein, da sie sonst die Spannung an V_{cc} auf eine Höhe zieht, die zum Öffnen der CMOS-Logik ausreichen kann.

Das bislang beschriebene Testverfahren besteht also darin (siehe Fig. 2), zunächst den Signalpin O als Emitter und den Masseanschlußpin GND als Basis sowie den Signalpin I als Kollektor zu beschalten und den Strom zu messen. Sodann wird I stromlos gesetzt und an V_{cc} die dort zuvor gemessene Zusatzspannung angelegt und der fließende Zusatzstrom gemessen. Anschließend wird der Zusatzstrom von dem zuvor gemessenen Kollektorstrom abgezogen. Es ergibt sich der korrigierte Kollektorstrom, der nur durch den Testtransistor D₂, D₁ fließt.

Diese Messung des wahren Stromes des Testtransistors kann alternativ auch auf andere Weise erfolgen:

Im ersten Schritt wird, wie bereits beschrieben, der Testtransistor an den Pins O, GND und I mit E, B und C kontaktiert und der Kollektorstrom bestimmt. Es wird dabei, wie bereits erwähnt, die Zusatzspannung an V_{cc} bestimmt.

Der zweite Meßschritt unterscheidet sich. Es wird hier nicht ein Transistor ausgemessen. O und GND werden gesperrt. Es wird nur an I die vorher verwendete Kollektorspannung und an Vcc die zuvor gemessene Zusatzspannung angelegt. Dann fließt durch die Diode D₅ genau der Strom, der in der vorhergehenden Messung den Zusatztransistor D₃, D₁ als Kollektorstrom gespeist hat. Durch die Diode D₅ fließt also genau der zu ermittelnde Zusatzstrom. Dieser wird an den Anschlüssen C oder Z des Testers T gemessen und kann anschließend von dem zuvor an I gemessenen Gesamtkollektorstrom beider Transistoren, also des Testtransistors einschließlich des Zusatztransistors abgezogen werden zur Ermittlung des wahren Stromes des Testtransistors D₂, D₁.

Es ist eine weitere alternative Meßweise möglich mit anderer Beschaltung der Testvorrichtung wie folgt:

In nur einem Meßschritt wird der Testtransistor an den Pins I, GND und O mit C, B und E kontaktiert, wie in Fig. 2 dargestellt. Gleichzeitig wird mit dem Zusatzanschluß Z des Testers T der Versorgungsspannungspin V_{cc} des ICs kontaktiert, und zwar mit einer Zusatzspannung, die genau der Kollektorspannung an I entspricht. Der Zusatzanschluß Z des Testers T muß zu diesem Zweck jedoch als getrennte Spannungsquelle ausgebildet werden, so daß die an dem Anschluß C und die an dem Anschluß Z fließenden Ströme getrennt voneinander bestimmbar sind.

Bei dieser Meßweise liegen an I und an Vcc dieselbe Spannung. Die Diode D₅ ist folglich stromlos. Durch D₅ kann kein Strom fließen. Die durch I und Vcc fließenden Ströme sind folglich voneinander unabhängig. An I, also am Kollektoranschluß C des Testers T kann daher der Kollektorstrom des Testtransistors D₂, D₁ gemessen werden, und zwar unabhängig vom Zusatzstrom. Eine gesonderte Ermittlung des Zusatzstromes und anschließende Differenzbildung kann in diesem Fall entfallen.

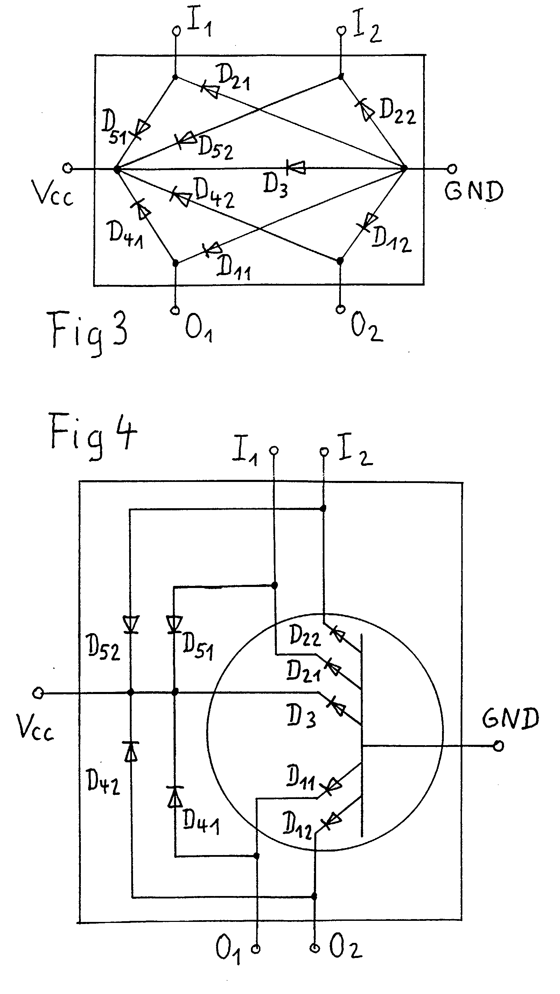

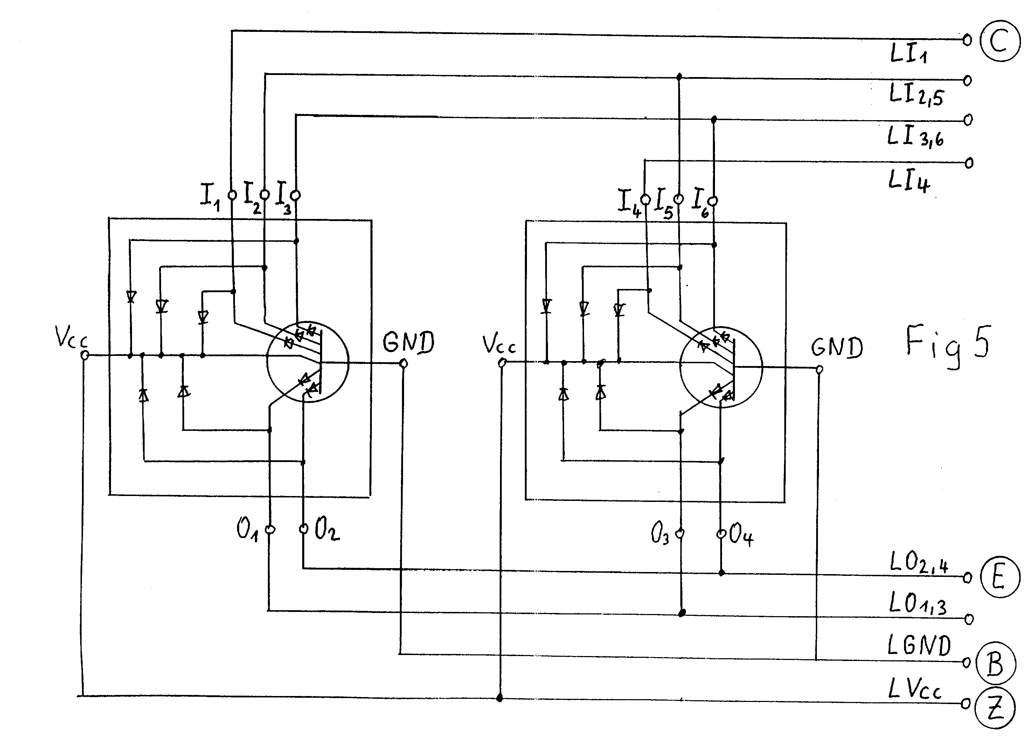

Der in den Fig. 1 und 2 dargestellte IC mit nur zwei Signalpins stellt eine starke Vereinfachung zu Erläuterungszwecken dar. Handelsübliche ICs haben normalerweise wesentlich mehr Signalpins. Bei modernen hochintegrierten ICs kann die Zahl der Signalpins bis weit über 100 gehen. Um zu erläutern, wie die Verhältnisse in einem IC bei vielen Signalpins sind, ist in den Fig. 3 und 4 in entsprechender Darstellung, wie in den Fig. 1 und 2, ein IC mit vier Signalpins dargestellt, die in beliebiger Weise Ein- oder Ausgänge sein können. In der Darstellung sind sie mit I₁, I₂, O₁ und O₂ bezeichnet.

In Fig. 3 sind die bipolaren Dioden eingezeichnet, und zwar mit einer Numerierung entsprechend der in Fig. 1, jeweils mit einer zweiten Indexzahl, die auf den Pin verweist. Es gibt aber nur eine Diode D₃ zwischen V_{cc} und GND. Jeder Signalpin ist mit einer Diode nach GND und mit einer Diode nach V_{cc} verbunden. Es sind also mehrere Testtransistoren abgreifbar mit Basis an GND, Kollektor an einem der Signalpins und Emitter an einem beliebigen der anderen Signalpins.

Jedem der auf diese Weise mit Kollektor an einem der Signalpins und Emitter an einem anderen der Signalpins bildbaren Testtransistoren liegt stets ein Zusatztransistor parallel mit Kollektor an V_{cc} und Spannungsversorgung über die von dem als Kollektor angeschlossenen Signalpins zu V_{cc} liegende Diode.

Werden nur die Signalpins I₁ und I₂ als Kollektoren und die Signalpins O₁ und O₂ als Emitter verwendet, so ergibt sich die Transistordarstellung der Fig. 4 mit dem in einem Kreis dargestellten Transistor, der die Kollektordioden D₂₂, D₂₁ und D₃ aufweist sowie die Emitterdioden D₁₁ und D₁₂ und der die gemeinsame Basis an GND hat.

Fig. 3 zeigt, daß hier wiederum die Signalpins I₁, I₂, O₁ und O₂ völlig identisch mit Dioden beschaltet sind. Es ist nicht erforderlich, stets den Kollektor eines Transistors an einen I-Pin und den Emitter an einen O-Pin zu legen. Es kann auch ein Transistor beispielsweise zwischen O₁ und O₂ gebildet werden, wobei dann die Dioden D₁₁ und D₁₂ die Kollektor- bzw. Emitterdiode eines Transistors bilden. Die Transistordarstellung der Fig. 4 ist dann entsprechend umzuzeichnen. Die Verwendung nur von Eingangspins I als Kollektor und nur von Ausgangspins O als Emitter kann jedoch vorteilhaft sein, da dann alle bildbaren Testtransistoren untereinander ähnlichere Werte haben.

Fig. 5 zeigt, zur Verdeutlichung einer realen Testsituation, zwei ICs in Darstellung gemäß Fig. 4, jedoch mit je fünf Signalpins. Die beiden ICs sind auf einer nicht dargestellten Platine eingelötet, also mit ihren Pins mit Leiterbahnen elektrisch verbunden. Die Signalpins der beiden dargestellten ICs sind der Übersichtlichkeit halber in der Darstellung jeweils oben und unten durchnumeriert. Die Leiterbahnen, mit denen die Pins verbunden sind, sind entsprechend mit vorgestellten Buchstaben "L" bezeichnet.

Der Signalpin I₁ des linken ICs ist einzeln mit einer Leiterbahn LI₁ verbunden. Der Signalpin I₂ des linken ICs und der Signalpin I₅ des rechten ICs sind gemeinsam an eine Leiterbahn LI_{2,5} angeschlossen. Der Signalpin I₃ des linken ICs ist gemeinsam mit einem Signalpin I₆ des rechten ICs an eine Leiterbahn LI_{3,6} angeschlossen. Der Signalpin I₄ des rechten ICs ist einzeln an eine Leiterbahn LI₄ angeschlossen. Der Signalpin O des linken ICs und der Signalpin O₃ des rechten ICs sind gemeinsam an eine Leiterbahn LO_{1,3} angeschlossen. Der Signalpin O₂ des linken ICs ist zusammen mit dem Signalpin O₄ des rechten Ics an eine Leiterbahn LO_{2,4} angeschlossen V_{cc} und GND beider Signalpins sind an gemeinsame Leiterbahnen LV_{cc} und LGND angeschlossen.

Es handelt sich um eine übliche parallel vernetzte Verschaltung von ICs, bei der sehr viele Signalpins parallel an Busleitungen angeschlossen sind. Diese Platine soll mit dem in Fig. 2 dargestellten Tester T mit den an den Enden seiner Anschlußleitungen dargestellten Anschlüssen B (Basis), E (Emitter = Masse des Testers), C (Kollektor) und Z (Zusatz) kontaktiert werden, um durch Bestimmung von Transistorströmen festzustellen, ob alle Pins der ICs korrekt mit den Leiterbahnen kontaktiert sind. Die Leiterbahnen werden dazu an ihren in Fig. 5 jeweils am rechten Ende dargestellten Kontakten kontaktiert.

Dabei wird immer die LGND-Leiterbahn mit B kontaktiert, da die Basis zu messender Testtransistoren stets an GND liegt. Z liegt stets an LV_{cc}. C und E können mit beliebigen der mit Signalpins verbundenen Leiterbahnen verbunden werden.

Im dargestellten Beispiel ist C mit der Leiterbahn LI₁ verbunden und E mit der Leiterbahn LO_{2,4}. Es handelt sich hierbei um ein günstig gewähltes Beispiel, weil an den Kollektoranschluß C des Testers nur ein isoliert angeschlossener Signalpin I₁ angeschlossen ist. Es wird also nur der mit der Diode D₂₁ des linken ICs als Kollektordiode gebildete Testtransistor angeschlossen. Diesem liegt aber durch Versorgung über die Diode D₅₁ der Zusatztransistor D₃, D₁₁ im linken IC parallel und da O₂ mit O₄ verbunden ist und V_{cc} beider ICs verbunden sind, auch der entsprechende Zusatztransistor im rechten IC.

Der Kollektorstrom an I₁, der sehr schwach ist, würde vom Hintergrundstrom der beiden Zusatztransistoren in den beiden ICs, die parallel liegen, völlig überlagert und könnte nicht erkannt werden. Der in Fig. 2 dargestellte Tester T ist aber mit seinem Zusatzanschluß an LV_{cc} angeschlossen und führt die zuvor beschriebenen Messungen aus, bei denen er den Kollektorstrom des Testtransistors mit Kollektor an I₁ unabhängig vom Zusatzstrom der beiden Zusatztransistoren in den beiden dargestellten ICs bestimmen kann. Er kann dazu ein beliebiges der drei eingangs erläuterten Verfahren anwenden, bevorzugt jedoch das zuerst verwendete Verfahren, bei dem nacheinander der Gesamtstrom und der Zusatzstrom des aktiven Zusatztransistors bestimmt werden und anschließend der Zusatzstrom von dem zuvor bestimmten Gesamtkollektorstrom zur Ermittlung des korrigierten Kollektorstroms des Testtransistors abgezogen wird. Dieses Verfahren hat sich in Versuchen als besonders geeignet erwiesen.

Mit einer solchen Messung kann der mit Kollektor an I₁ gebildete Testtransistor in seinen Eigenschaften, wie beispielsweise Stromverstärkung, Kennlinien od.dgl. genau ausgemessen werden, und es kann ermittelt werden, ob dieser Transistor auch wirklich voll funktionsfähig angeschlossen ist. Ist dies der Fall, so ergibt sich daraus die Aussage, daß die beteiligten Pins des ICs, also I₁ und O₂ korrekt kontaktiert, also korrekt mit den zugehörigen Leiterbahnen verlötet sind.

Zur Überprüfung der korrekten Kontaktierung der beiden dargestellten ICs werden bevorzugt Testtransistoren benutzt, deren Kollektor oder Emitter allein an eine Leiterbahn angeschlossen ist. Es kann also im rechten IC bevorzugt der Pin I₄ als Kollektor verwendet werden.

Werden die gemeinsam mit der Leiterbahn LI_{2,5} verbundenen Signalpins 12 und I₅ als Kollektor verwendet, so ergibt sich ein Testtransistor mit Doppelkollektor, also auch mit doppeltem Strom. Ob beide Kollektoren bei I₂ und I₅ korrekt kontaktiert sind, muß in diesem Falle daraus geschlossen werden, daß der aus I₂ und I₅ gebildete Doppelkollektor den doppelten Kollektorstrom ergibt als bei Messung der Testtransistoren mit Kollektor an I₁ oder an I₄. Es kann aber auch beispielsweise in dem rechts dargestellten IC der Signalpin I₄ als Kollektor und der Signalpin I₅ als Emitter verwendet werden. Dann ist eine Aussage über die korrekte Kontaktierung dieser beiden Signalpins möglich.

Bei Benutzung von I₁ als Kollektor und O₁ als Emitter, wenn also E an LO_{1,3} gelegt ist, ergibt sich eine Aussage über die korrekte Kontaktierung von O₁. Wird bei Verwendung von I₁ als Kollektor O₂ über LO_{2,4} an E angeschlossen, so ergibt sich eine Aussage über die korrekte Kontaktierung von O₂. Entsprechend kann zur Überprüfung von O₃ und O₄ verfahren werden unter Verwendung von I₄ als Kollektor.

Auf die beschriebene Weise können an allen bildbaren Testtransistoren die korrigierten Kollektorströme gemessen werden, also die Ströme, die nur durch den jeweiligen Testtransistor fließen. Dabei sind die zumeist wesentlich höheren Zusatzströme der Zusatztransistoren, die zumeist noch aus mehreren parallelen Zusatztransistoren paralleler ICs stammen, herauskorrigiert.

Um bei Anschluß des Testers T an einen bestimmten Testtransistor zu entscheiden, ob die kontaktierten Pins auch wirklich mit den Leiterbahnen verbunden sind, können typische Transistoreigenschaften, wie z.B. Stromverstärkung oder Transistorkennlinie, bestimmt werden. Es läßt sich dann die Aussage treffen, ob wirklich ein korrekt arbeitender Transistor kontaktiert ist. Ist dies der Fall, so ist sichergestellt, daß die betreffenden Pins korrekt mit den Leiterbahnen verbunden sind.

Man kann aber auch nur in einer einfachen Messung den Kollektorstrom eines Testtransistors bestimmen und überprüfen, ob bei den angelegten Basis- und Kollektorspannungen der gemessene Kollektorstrom dem von einem solchen Testtransistor zu erwartenden Strom entspricht. Da die Kollektorströme von Testtransistoren eines IC-Typs bei ICs unterschiedlicher Hersteller oder aus unterschiedlichen Herstellungschargen sehr stark unterschiedlich sein können, gelingt dies nicht ohne weiteres. So kann beispielsweise bei Messung des korrigierten Kollektorstromes des in Fig. 5 aus I₁ als Kollektor und O₁ als Emitter angeschlossenen Testtransistors bei einem IC eines Herstellers ein Kollektorstrom von 10 mA fließen, bei demselben Testtransistor desselben IC-Typs eines anderen Herstellers aber bei Anlegen derselben Basis- und Kollektorspannungen ein Kollektorstrom von beispielsweise nur 10 µA. Beim routinemäßigen Durchtesten vieler Platinen, die mit ICs unterschiedlicher Hersteller abwechselnd bestückt sind, kann in dem oben erwähnten zweiten Fall nicht entschieden werden, ob es sich bei dem Kollektorstrom von 10 µA um den korrekten Kollektorstrom für einen IC des zweiten Herstellers handelt oder ob ein IC des ersten Herstellers vorliegt, bei dem der Kollektorstrom 10 mA betragen müßte, der gemessene Wert also viel zu niedrig ist und auf einen Defekt hinweist.

Um dennoch auf die beschriebene einfache Weise mit nur einer Kollektorstrommessung korrekte Werte zu ermitteln, wird von der Erkenntnis Gebrauch gemacht, daß sich bei ICs desselben Typs unterschiedlicher Hersteller oder unterschiedlicher Herstellungschargen die Kollektorströme der unterschiedlichen Testtransistoren des ICs alle im wesentlichen proportional verändern. Werden die einzelnen Kollektorströme der Testtransistoren also mit dem Mittelwert der Kollektorströme aller Testtransistoren verglichen, so sind diese normierten Werte unabhängig von Hersteller oder Charge.

Dabei können bei ICs unterschiedlicher Hersteller oder Chargen jedoch die Mittelwerte verschiedener Gruppen von Testtransistoren sich unterschiedlich verändern. Beispielsweise können Testtransistoren mit einem Eingangspin als Kollektor und einem Ausgangspin als Emitter im Mittelwert ihrer Kollektorströme sich anders ändern als Testtransistoren einer Gruppe mit einem Ausgangspin als Kollektor und einem Eingangspin als Emitter. Daher werden vorteilhaft die Kollektorströme der Testtransistoren mit den Mittelwerten der entsprechenden Gruppe von Testtransistoren verglichen, bei denen Kollektoren und Emitter vom selben Pintyp sind. Als Pintypen liegen üblicherweise vor Eingangspins, Ausgangspins, Enable-Pins, Chipselect-Pins etc.

Dies wird nun in einem Beispiel anhand Fig. 5 erläutert. Bei dem linken IC sollen sämtliche Pins auf korrekte Kontaktierung mit den Leiterbahnen überprüft werden. Es werden also mit dem Tester Testtransistoren hinsichtlich ihrer korrigierten Kollektorströme gemessen, wobei es gelingt, unter Ausmessung von vier Testtransistoren alle fünf Pins I₁, I₂, I₃, O₁ und O₂ zu untersuchen. Es handelt sich dabei um die folgenden Testtransistoren, die jeweils angegeben sind in der Schreibweise "Kollektor-Emitter", also um die Transistoren I₁ - O₁, I₁ - O₂, I₃ - I₁ sowie I₂ - I₁.

Im folgenden wird in einer Tabelle 1 ein Meßergebnis angegeben. Die erste Spalte der Tabelle gibt an, welcher Pin als Kollektor angeschlossen ist. Die zweite Spalte gibt an, welcher Pin als Emitter angeschlossen ist. In der dritten Spalte ist der jeweils korrigierte Kollektorstrom angegeben. Die vierte Spalte enthält den Mittelwert der Kollektorströme und die letzte Spalte für jeden Testtransistor den in bezug auf den Mittelwert normierten Kollektorstrom, also das Verhältnis von Kollektorstrom zu Mittelwert.

Die Tabelle ist in zwei Gruppen unterteilt. Die obere Gruppe I - O enthält zwei Testtransistoren, bei denen jeweils der Kollektor ein I-Pin und der Emitter ein O-Pin ist. Die zweite Gruppe I - I enthält zwei Testtransistoren, bei denen sowohl Kollektor als auch Emitter ein I-Pin sind.

In Tabelle 1 ist ein IC eines Herstellers A untersucht. Für jeden Transistor ist der Kollektorstrom angegeben. Es handelt sich hier um einen IC, der bei diesem Hersteller sehr niedrige Kollektorströme im µA-Bereich aufweist. Es sind die Mittelwerte für die beiden Gruppen angegeben und die normierten Werte, die für die vier gemessenen Testtransistoren von oben nach unten 0,93, 1,06, 0,90 und 1,09 betragen.

**Tabelle 1**

| Hersteller: A | | | | |
|---|---|---|---|---|
| Kollektor | Emitter | Kollektorstrom | Mittelwert | normierter Wert |
| Gruppe I - O | | | | |
| I₁ | O₁ | 20 µA | | 0,93 |
| | | | 21,5 µA | |
| I₁ | 0₂ | 23 µA | | 1,06 |

| Gruppe I - I | | | | |
|---|---|---|---|---|
| I₃ | I₁ | 10 µA | | 0,90 |
| | | | 11 µA | |
| I₂ | I₁ | 12 µA | | 1,09 |

In Tabelle 2 sind in derselben Tabellenanordnung dieselben Testtransistoren eines ICs desselben Typs mit denselben Basis- und Kollektorspannungen vermessen worden. Dieser IC stammt jedoch von einem Hersteller B, bei dem, wie die Tabelle zeigt, die Kollektorströme wesentlich höher liegen, nämlich im mA-Bereich. Es sind wiederum die Mittelwerte der beiden Gruppen gebildet und die normierten Werte berechnet worden. Es zeigt sich, daß die normierten Werte dieses Testtransistors denen der Tabelle 1 entsprechen.

**Tabelle 2**

| Hersteller: B | | | | |
|---|---|---|---|---|
| Kollektor | Emitter | Kollektorstrom | Mittelwert | normierter Wert |
| Gruppe I - O | | | | |
| I₁ | O₁ | 5,0 mA | | 0,93 |
| | | | 5,35 mA | |
| I₁ | 0₂ | 5,7 mA | | 1,06 |

| Gruppe I - I | | | | |
|---|---|---|---|---|
| I₃ | I₁ | 3,0 mA | | 0,93 |
| | | | 3,2 mA | |
| I₂ | I₁ | 3,5 mA | | 1,09 |

Zu Beginn einer Testserie, bei der eine bestimmte Platine zu überprüfen ist, kann eine als gut befundene Platine, ein sogenanntes Gut-Board ausgemessen werden, und es werden für alle gemessenen Testtransistoren der verschiedenen ICs, unterteilt nach den oben beschriebenen Gruppen, wie in Tabelle 1 oder 2 angegeben, die normierten Werte der Testtransistoren bestimmt und in einer Tabelle abgespeichert. Sodann werden die zu testenden Boards getestet, und es werden die normierten Werte der jeweiligen Testtransistoren mit den normierten Werten der entsprechenden Testtransistoren des Gut-Boards verglichen. Wie der Vergleich der Tabelle 1 mit Tabelle 2 zeigt, können hierbei sehr genau Fehler erkannt werden, unabhängig davon, ob die IC-Bestückung mit ICs derselben oder unterschiedlicher Herstellungschargen oder Hersteller vorgenommen wurde.

## Patentansprüche

1. Testvorrichtung zur Überprüfung der korrekten Verbindung der Pins eines eingelöteten ICs mit den Leiterbahnen einer Platine, mit einem mit den Leiterbahnen kontaktierbaren Tester (T), der an einen der Signalpins (O) des ICs mit seinem Masseanschluß (E), an den Massepin (GND) des ICs mit einem eine zum Öffnen eines Transistors geeignete Basisspannungen liefernden Basisausgang (B) und an einen weiteren Signalpin (I) des ICs mit einem Kollektoranschluß (C) anschließbar ist, der zur Lieferung von zur Erzeugung von Kollektorströmen geeigneten Kollektorspannungen sowie zur Messung der entsprechenden Kollektorströme ausgebildet ist, **dadurch gekennzeichnet**, daß der Tester (T) einen an den Versorgungsspannungspin (V_{cc}) des ICs anschließbaren Zusatzanschluß (Z) aufweist und in zwei Betriebsarten umschaltbar ist, wobei bei beiden Betriebsarten der Basisanschluß (B) dieselbe Basisspannung anlegt, wobei in der ersten Betriebsart der Kollektoranschluß (C) eine Kollektorspannung anlegt und den zugehörigen Kollektorstrom bestimmt, während der Zusatzanschluß (Z) stromfrei geschaltet ist und die am Versorgungsspannungspin (V_{cc}) resultierende Zusatzspannung bestimmt und wobei in der zweiten Betriebsart der Kollektoranschluß (C) gesperrt ist und der Zusatzanschluß (Z) an den Versorgungsspannungspin (V_{cc}) die in der ersten Betriebsart dort gemessene Zusatzspannung anlegt und den dabei fließenden Zusatzstrom bestimmt.

2. Testvorrichtung zur Überprüfung der korrekten Verbindung der Pins eines eingelöteten ICs mit den Leiterbahnen einer Platine, mit einem mit den Leiterbahnen kontaktierbaren Tester (T), der an einen der Signalpins (O) des ICs mit seinem Masseanschluß (E), an den Massepin (GND) des ICs mit einem eine zum Öffnen eines Transistors geeignete Basisspannungen liefernden Basisausgang (B) und an einen weiteren Signalpin (I) des ICs mit einem Kollektoranschluß (C) anschließbar ist, der zur Lieferung von zur Erzeugung von Kollektorströmen geeigneten Kollektorspannungen sowie zur Messung der entsprechenden Kollektorströme ausgebildet ist, **dadurch gekennzeichnet**, daß der Tester (T) einen an den Versorgungsspannungspin (V_{cc}) des ICs anschließbaren Zusatzanschluß (Z) aufweist und in zwei Betriebsarten umschaltbar ist, wobei in beiden Betriebsarten der Kollektoranschluß (C) dieselbe Kollektorspannung anlegt und den jeweils zugehörigen Kollektorstrom bestimmt, wobei in der ersten Betriebsart der Basisanschluß (B) eine Basisspannung anlegt, der Masseanschluß angeschlossen ist und der Zusatzanschluß (Z) stromfrei geschaltet ist und die Zusatzspannung am Versorgungsspannungspin (V_{cc}) bestimmt und wobei in der zweiten Betriebsart der Basisanschluß sowie der Masseanschluß gesperrt sind und der Zusatzanschluß (Z) die in der ersten Betriebsart gemessene Zusatzspannung anlegt.

3. Testvorrichtung zur Überprüfung der korrekten Verbindung der Pins eines eingelöteten ICs mit den Leiterbahnen einer Platine, mit einem mit den Leiterbahnen kontaktierbaren Tester (T), der an einen der Signalpins (O) des ICs mit seinem Masseanschluß (E), an den Massepin (GND) des ICs mit einem eine zum Öffnen eines Transistors geeignete Basisspannungen liefernden Basisausgang (B) und an einen weiteren Signalpin (I) des ICs mit einem Kollektoranschluß (C) anschließbar ist, der zur Lieferung von zur Erzeugung von Kollektorströmen geeigneten Kollektorspannungen sowie zur Messung der entsprechenden Kollektorströme ausgebildet ist, **dadurch gekennzeichnet**, daß der Tester (T) einen an den Versorgungsspannungspin (V_{cc}) des ICs anschließbaren, von seinen übrigen Anschlüssen getrennten Zusatzanschluß (Z) aufweist und derart ausgebildet ist, daß der Basisausgang (B) eine Basisspannung anlegt, der Kollektoranschluß (C) eine Kollektorspannung anlegt und den zugehörigen Kollektorstrom bestimmt und der Zusatzanschluß (Z) mit einer getrennten Spannungsquelle eine Zusatzspannung anlegt, die gleich der Kollektorspannung ist.

4. Testvorrichtung nach Anspruch 1, **dadurch gekennzeichnet**, daß der Tester (T) derart ausgebildet ist, daß er in beiden Betriebsarten nacheinander Messungen ausführt und den als Differenz von Kollektorstrom und Zusatzstrom sich ergebenden korrigierten Kollektorstrom berechnet.

5. Testvorrichtung nach Anspruch 2, **dadurch gekennzeichnet**, daß der Tester (T) derart ausgebildet ist, daß er in beiden Betriebsarten nacheinander Messungen ausführt und den als Differenz der beiden gemessenen Kollektorströme sich ergebenden korrigierten Kollektorstrom berechnet.

6. Testvorrichtung nach einem der vorhergehenden Ansprüche, **dadurch gekennzeichnet**, daß der Tester (T) die korrigierten Kollektorströme aller gemessener Testtransistoren (I₁ - O₁, I₁ - O₂, I₃ - I₁, I₂ - I₁) eines ICs durch den arithmetischen Mittelwert der Kollektorströme teilt und diese normierten Kollektorströme zur Anzeige bringt.

7. Testvorrichtung nach Anspruch 6, **dadurch gekennzeichnet**, daß der Tester (T) die Normierung jeweils mit dem Mittelwert der Kollektorströme der zugehörigen Gruppe von Testtransistoren ausführt, die Kollektoren und Emitter derselben Pinartkombination (I-O, O-I, I-I, O-O) aufweisen.

8. Testverfahren zur Überprüfung der korrekten Verbindung der Pins eines eingelöteten ICs mit den Leiterbahnen einer Platine durch Anlegen von Masse (E) an einen der Signalpins (O) des ICs, durch Anlegen einer zum Öffnen eines Transistors (D₂, D₁) geeigneten Basisspannung (B) an den Massepin (GND) des ICs sowie durch Anlegen einer Kollektorspannung (C) an einen weiteren Signalpin (I) des ICs und Messung des Kollektorstromes, **dadurch gekennzeichnet**, daß gleichzeitig die auftretende Zusatzspannung an dem Versorgungsspannungspin (V_{cc}) des ICs gemessen wird, daß anschließend nach Abschalten der Kollektorspannung unter Anlegen derselben Masse und Basisspannung an dieselben Pins (O, GND) die zuvor gemessene Zusatzspannung an den Versorgungsspannungspin (V_{cc}) angelegt und der dort fließende Zusatzstrom bestimmt wird und daß aus der Differenz von Kollektorstrom und Zusatzstrom der korrigierte Kollektorstrom bestimmt wird.

9. Testverfahren zur Überprüfung der korrekten Verbindung der Pins eines eingelöteten ICs mit den Leiterbahnen einer Platine durch Anlegen von Masse (E) an einen der Signalpins (O) des ICs, durch Anlegen einer zum Öffnen eines Transistors (D₂, D₁) geeigneten Basisspannung (B) an den Massepin (GND) des ICs sowie durch Anlegen einer Kollektorspannung (C) an einen weiteren Signalpin (I) des ICs und Messung des Kollektorstromes, **dadurch gekennzeichnet**, daß gleichzeitig die auftretende Zusatzspannung an dem Versorgungsspannungspin (V_{cc}) des ICs gemessen wird, daß anschließend unter Abschaltung von Masse und Basisspannung die zuvor gemessene Zusatzspannung an den Versorgungsspannungspin (V_{cc}) angelegt, die zuvor verwendete Kollektorspannung an denselben Pin (I) wie zuvor angelegt und der nun fließende Kollektorstrom gemessen wird und daß aus der Differenz der beiden gemessenen Kollektorströme der korrigierte Kollektorstrom bestimmt wird.

10. Testverfahren zur Überprüfung der korrekten Verbindung der Pins eines eingelöteten ICs mit den Leiterbahnen einer Platine durch Anlegen von Masse (E) an einen der Signalpins (O) des ICs, durch Anlegen einer zum Öffnen eines Transistors (D₂, D₁) geeigneten Basisspannung (B) an den Massepin (GND) des ICs sowie durch Anlegen einer Kollektorspannung (C) an einen weiteren Signalpin (I) des ICs und Messung des Kollektorstromes, **dadurch gekennzeichnet**, daß gleichzeitig eine der Kollektorspannung entsprechende Zusatzspannung von einer getrennten Spannungsquelle (Z) an den Versorgungsspannungspin (V_{cc}) gelegt wird.

11. Testverfahren nach einem der Ansprüche 8 bis 10, **dadurch gekennzeichnet**, daß die korrigierten Kollektorströme aller gemessener Testtransistoren (I₁ - O₁, I₁ - O₂, I₃ - I₁, I₂ - I₁) eines Ics durch den arithmetischen Mittelwert der Kollektorströme geteilt und diese normierten Kollektorströme zur Anzeige gebracht werden.

12. Testverfahren nach Anspruch 11, **dadurch gekennzeichnet**, daß die Normierung der Kollektorströme mit Mittelwerten zugehöriger Gruppen von Testtransistoren durchgeführt wird, welche Kollektoren und Emitter gleicher Pinart (I bzw. O) aufweisen.

13. Testverfahren nach einem der Ansprüche 11 oder 12, **dadurch gekennzeichnet**, daß die normierten Kollektorströme der gemessenen Testtransistoren eines zu prüfenden ICs mit den auf dieselbe Weise normierten Kollektorströmen derselben Testtransistoren einer zuvor gemessenen einwandfreien Platine verglichen werden.

## Claims

1. A testing device for checking the correct connection of the pins of a soldered integrated circuit to the strip conductors of a board, with a tester (T) which is contactable with the strip conductors and which, with its earth connection (E), is connectable to one of the signal pins (O) of the integrated circuit, with a base output (B) supplying suitable base voltages for opening a transistor, is connectable to the earth pin (GND) of the integrated circuit and with a collector connection (C) is connectable to a futher signal pin (I) of the integrated circuit, said collector connection being designed for supplying collector voltages suitable for producing collector currents as well as being designed for measuring the corresponding collector currents, **characterised in that** the tester (T) comprises an additional connection (Z) connectable to the supply voltage pin (V_{cc}) of the integrated circuit and can be switched to two operating modes, wherein the base connection (B) applies the same base voltage in both operating modes, wherein in the first operating mode, the collector connection (C) applies a collector voltage and determines the accompanying collector current, whilst the additional connection (Z) is switched without current and determines the resulting additional voltage at the supply voltage pin (V_{cc}) and wherein in the second operating mode the collector connection (C) is blocked and the additional connection (Z) applies to the supply voltage pin (V_{cc}) the additional voltage measured here in the first operating mode and determines the additional current flowing at the same time.

2. A testing device for checking the correct connection of the pins of a soldered integrated circuit to the strip conductors of a board, with a tester (T) which is contactable with the strip conductors and which, with its earth connection (E), is connectable to one of the signal pins (O) of the integrated circuit, with a base output (B) supplying suitable base voltages for opening a transistor, is connectable to the earth pin (GND) of the integrated circuit and with a collector connection (C) is connectable to a futher signal pin (I) of the integrated circuit, said collector connection being designed for supplying collector voltages suitable for producing collector currents as well as being designed for measuring the corresponding collector currents, **characterised in that** the tester (T) comprises an additional connection (Z) connectable to the supply voltage pin (V_{cc}) of the integrated circuit and can be switched to two operating modes, wherein in both operating modes the collector connection (C) applies the same collector voltage and determines in each case the accompanying collector current, wherein in the first operating mode the base connection (B) applies a base voltage, the earth connection is connected and the additional connection (Z) is switched without current and determines the additional voltage at the supply voltage pin (V_{cc}) and wherein in the second operating mode the base connection as well as the earth connection are blocked and the additional connection (Z) applies the additional voltage measured in the first operating mode.

3. A testing device for checking the correct connection of the pins of a soldered integrated circuit to the strip conductors of a board, with a tester (T) which is contactable with the strip conductors and which, with its earth connection (E), is connectable to one of the signal pins (O) of the integrated circuit, with a base output (B) supplying suitable base voltages for opening a transistor, is connectable to the earth pin (GND) of the integrated circuit and with a collector connection (C) is connectable to a futher signal pin (I) of the integrated circuit, said collector connection being designed for supplying collector voltages suitable for producing collector currents as well as being designed for measuring the corresponding collector currents, **characterised in that** the tester (T) comprises an additional connection (Z) which is connectable to the supply voltage pin (V_{cc}) of the integrated circuit and separated from the remaining connections of said tester, and said tester is designed such that the base output (B) applies a base voltage, the collector connection (C) applies a collector voltage and determines the accompanying collector current and the additional connection (Z) with a separate voltage source applies an additional voltage which is equal to the collector voltage.

4. A testing device according to claim 1, **characterised in that** the tester (T) is designed such that in both operating modes it carries out measurements in succession and calculates the resulting corrected collector current as the difference of the collector current and the additional current.

5. A testing device according to claim 2, **characterised in that** the tester is designed such that in both operating modes it carries out measurements in succession and calculates the resulting corrected collector current as the difference of both measured collector currents.

6. A testing device according to one of the preceding claims, **characterised in that** the tester (T) divides the corrected collector currents of all measured test transistors (I₁ - O₁, I₁ - O₂, I₃ -I₁, I₂ - I₁) of an integrated circuit by the arithmetical mean value of the collector currents and indicates these normalised collector currents.

7. A testing device according to claims 6, **characterised in that** the tester (T) carries out the normalisation in each case with the mean value of the collector currents of the accompanying group of test transistors which comprise the collectors and emitters of the same pin-type combination (I-O, O-I, I-I, O-O).

8. A testing method for checking the correct connection of the pins of a soldered integrated circuit to the strip conductors of a board by applying earth (E) to one of the signal pins (O) of the integrated circuit, by applying a base voltage (B) suitable for opening a transistor (D₂, D₁) to the earth pin (GND) of the integrated circuit as well as by applying a collector voltage (C) to a further signal pin (I) of the integrated circuit and measuring the collector current, **characterised in that** the arising additional voltage at the supply voltage pin (V_{cc}) of the integrated circuit is simultaneously measured, that subsequently after cutting off the collector voltage whilst applying the same earth and base voltage to the same pins (O, GND), the previously measured additional voltage is applied to the supply voltage pin (V_{cc}) and the additional current flowing here is determined and that from the difference of the collector current and the additional current the corrected collector current is determined.

9. A testing method for checking the correct connection of the pins of a soldered integrated circuit to the strip conductors of a board by applying earth (E) to one of the signal pins (O) of the integrated circuit, by applying a base voltage (B) suitable for opening a transistor (D₂, D₁) to the earth pin (GND) of the integrated circuit as well as by applying a collector voltage (C) to a further signal pin (I) of the integrated circuit and measuring the collector current, **characterised in that** the arising additional voltage at the supply voltage pin (V_{cc}) of the integrated circuit is simultaneously measured, that subsequently whilst cutting off earth and the base voltage, the previously measured additional voltage is applied to the supply voltage pin (V_{cc}), the previously used collector voltage is applied to the same pin (I) as previously and the now flowing collector current is measured and that from the difference of both measured collector currents, the corrected collector current is determined.

10. A testing method for checking the correct connection of the pins of a soldered integrated circuit to the strip conductors of a board by applying earth (E) to one of the signal pins (O) of the integrated circuit, by applying a base voltage (B) suitable for opening a transistor (D₂, D₁) to the earth pin (GND) of the integrated circuit as well as by applying a collector voltage (C) to a further signal pin (I) of the integrated circuit and measuring the collector current, **characterised in that** simultaneously an additional voltage corresponding to the collector voltage is applied by a separate voltage source (Z) to the supply voltage pin (V_{cc}).

11. A testing method according to one of claims 8 to 10, **characterised in that** the corrected collector currents of all measured test transistors (I₁-O₁, I₁-O₂, I₃-I₁, I₂-I₁) of an integrated circuit are divided by the arithmetic mean value of the collector currents and these normalised collector currents are indicated.

12. A testing method according to claim 11, **characterised in that** the normalisation of the collector currents is carried out with the mean values of accompanying groups of test transistors which comprise collectors and emitters of the same pin-type (I or O).

13. A testing method according to one of claims 11 or 12, **characterised in that** the normalised collector currents of the measured test transistors of an integrated circuit to be checked are compared with the collector currents, normalised in the same manner, of the same test transistors of a previously measured faultless board.

## Revendications

1. Dispositif permettant de tester la connexion correcte des broches d'un CI soudé sur une platine et des bandes conductrices de cette platine, avec un testeur (T) pouvant contacter les bandes conductrices et être connecté à l'une des broches de signaux (O) du CI avec sa prise de masse (E), à la broche de masse (GND) du CI avec une sortie de base (B) susceptible de fournir une tension de base propre a déclencher l'ouverture d'un transistor, et à une autre broche de signaux (I) du CI avec une prise de collecteur (C) conçue de façon à pouvoir fournir des tensions de collecteur propres à générer des courants de collecteur et à permettre la mesure des courants de collecteur correspondants, **caractérisé en ce que** le testeur (T) présente une broche supplémentaire (Z) pouvant être connectée à la broche d'alimentation (V_{cc}) du CI, et peut être commuté entre deux différents modes de service, la base (B) appliquant dans les deux modes de service la même tension de base, le collecteur (C) appliquant dans le premier mode de service une tension de collecteur et déterminant le courant de collecteur correspondant alors que la broche supplémentaire (Z) reste sans courant et détermine la tension supplémentaire résultant au niveau de la broche d'alimentation (V_{cc}), et le collecteur (C) étant verrouillé dans le second mode de service alors que la broche supplémentaire (Z) applique à la broche d'alimentation (V_{cc}) la tension supplémentaire qui y a été mesurée dans le cadre du premier mode de service et détermine le courant supplémentaire qui en résulte.

2. Dispositif permettant de tester la connexion correcte des broches d'un CI soudé sur une platine et des bandes conductrices de cette platine, avec un testeur (T) pouvant contacter les bandes conductrices et être connecté à l'une des broches de signaux (O) du CI avec sa prise de masse (E), à la broche de masse (GND) du CI avec une sortie de base (B) susceptible de fournir une tension de base propre a déclencher l'ouverture d'un transistor, et à une autre broche de signaux (I) du CI avec une prise de collecteur (C) conçue de façon à pouvoir fournir des tensions de collecteur propres à générer des courants de collecteur et à permettre la mesure des courants de collecteur correspondants, **caractérisé en ce que** le testeur (T) présente une broche supplémentaire (Z) pouvant être connectée à la broche d'alimentation (V_{cc}) du CI, et peut être commuté entre deux différents modes de service, le collecteur (C) appliquant dans les deux modes de service la même tension de collecteur et déterminant le courant de collecteur correspondant, la base (B) appliquant dans le premier mode de service une tension de base alors que la prise de masse est connectée et que la broche supplémentaire (Z) est sans courant et détermine la tension supplémentaire au niveau de la broche d'alimentation (V_{cc}), la base ainsi que la prise de masse étant verrouillées dans le second mode de service alors que la broche supplémentaire (Z) applique la tension supplémentaire mesurée dans le cadre du premier mode de service.

3. Dispositif permettant de tester la connexion correcte des broches d'un CI soudé sur une platine et des bandes conductrices de cette platine, avec un testeur (T) pouvant contacter les bandes conductrices et être connecté à l'une des broches de signaux (O) du CI avec sa prise de masse (E), à la broche de masse (GND) du CI avec une sortie de base (B) susceptible de fournir une tension de base propre a déclencher l'ouverture d'un transistor, et à une autre broche de signaux (I) du CI avec une prise de collecteur (C) conçue de façon à pouvoir fournir des tensions de collecteur propres à générer des courants de collecteur et à permettre la mesure des courants de collecteur correspondants, **caractérisé en ce que** le testeur (T) présente une broche supplémentaire (Z) séparée de ses autres broches et pouvant être connectée à la broche d'alimentation (V_{cc}) du CI et conçue de façon à ce que la base (B) applique une tension de base, que le collecteur (C) applique une tension de collecteur et détermine le courant de collecteur correspondant, et que la broche supplémentaire (Z) applique à l'aide d'une source de tension séparée une tension supplémentaire égale à la tension de collecteur.

4. Dispositif de test selon la revendication 1, **caractérisé en ce que** le testeur (T) est conçu de façon à procéder dans le cadre des deux modes de service à des mesures successives et à calculer le courant de collecteur rectifié résultant de la différence entre le courant de collecteur et le courant supplémentaire.

5. Dispositif de test selon la revendication 1, **caractérisé en ce que** le testeur (T) est conçu de façon à procéder dans le cadre des deux modes de service à des mesures successives et à calculer le courant de collecteur rectifié résultant de la différence entre les deux courants de collecteur mesurés.

6. Dispositif de test selon l'une des revendications précédentes, **caractérisé en ce que** le testeur (T) divise les courants de collecteur rectifiés de tous les transistors de test mesurés (I₁ - O₁, I₁ - O₂, I₃ - I₁, I₂ - I₁) d'un CI par la moyenne arithmétique des courants de collecteur et affiche ce courant de collecteur normalisé.

7. Dispositif de test selon la revendication 6, **caractérisé en ce que** le testeur (T) effectue cette normalisation à partir des valeurs moyennes des courants de collecteur du groupe de transistors de test correspondants présentant des collecteurs et émetteurs de même combinaison de types de broche (I-O, O-I, I-I, O-O).

8. Procédé permettant de tester la connexion correcte des broches d'un CI soudé sur une platine et des bandes conductrices de cette platine en appliquant à l'une des broches de signaux (O) du CI la masse (E), en appliquant à la broche de masse (GND) du CI une tension de base (B) propre à ouvrir un transistor (D₂, D₁) ainsi qu'en appliquant à une autre broche de signaux (I) du CI une tension de collecteur (C) et en mesurant le courant de collecteur, **caractérisé en ce que** la tension supplémentaire apparaissant au niveau de la broche d'alimentation (V_{cc}) du CI est simultanément mesurée puis, après suppression de la tension de collecteur en appliquant la même masse et la même tension de base aux mêmes broches (O, GND), la tension supplémentaire précédemment mesurée est appliquée à la broche d'alimentation (V_{cc}) et le courant supplémentaire qui y circule est déterminé, et que le courant de collecteur corrigé est déterminé à partir de la différence entre le courant de collecteur et le courant supplémentaire.

9. Procédé permettant de tester la connexion correcte des broches d'un CI soudé sur une platine et des bandes conductrices de cette platine en appliquant à l'une des broches de signaux (O) du CI la masse (E), en appliquant à la broche de masse (GND) du CI une tension de base (B) propre à ouvrir un transistor (D₂, D₁) ainsi qu'en appliquant à une autre broche de signaux (I) du CI une tension de collecteur (C) et en mesurant le courant de collecteur, **caractérisé en ce que** la tension supplémentaire apparaissant au niveau de la broche d'alimentation (V_{cc}) du CI est simultanément mesurée puis, après suppression de la masse et de la tension de base, la tension supplémentaire précédemment mesurée est appliquée à la broche d'alimentation (V_{cc}) du CI, la tension de collecteur précédemment utilisée est appliquée à la même broche (I) que précédemment, le courant de collecteur qui circule maintenant est mesuré, et que le courant de collecteur corrigé est déterminé à partir de la différence entre les deux courants de collecteur.

10. Procédé permettant de tester la connexion correcte des broches d'un CI soudé sur une platine et des bandes conductrices de cette platine en appliquant à l'une des broches de signaux (O) du CI la masse (E), en appliquant à la broche de masse (GND) du CI une tension de base (B) propre à ouvrir un transistor (D₂, D₁) ainsi qu'en appliquant à une autre broche de signaux (I) du CI une tension de collecteur (C) et en mesurant le courant de collecteur, **caractérisé en ce qu'**une tension supplémentaire correspondant à la tension de collecteur est simultanément appliquée à la broche d'alimentation (V_{cc}) à l'aide d'une source de tension séparée.

11. Procédé de test selon l'une des revendications 8 à 10, **caractérisé en ce que** les courants de collecteur rectifiés de tous les transistors de test mesurés (I₁ - O₁, I₁ - O₂, I₃ - I₁, I₂ - I₁) d'un CI sont divisés par la moyenne arithmétique des courants de collecteur et que ce courant de collecteur normalisé est affiché.

12. Procédé de test selon la revendication 11, **caractérisé en ce que** la normalisation des courants de collecteur est calculée à partir des valeurs moyennes des groupes de transistors de test correspondants présentant des collecteurs et émetteurs de même type de broche (I ou O).

13. Procédé de test selon l'une des revendications 11 ou 12, **caractérisé en ce que** les courants de collecteur normalisés des transistors de test mesurés sur un CI à contrôler sont comparés avec les courants de collecteur normalisés de la même façon pour les mêmes transistors de test d'une platine libre de défauts précédemment soumise aux mesures.
